(19) Europäisches Patentamt
European Patent Office
Office européen des brevets

(11) EP 2 712 908 A2

(12) # EUROPEAN PATENT APPLICATION

(43) Date of publication:
**02.04.2014 Bulletin 2014/14**

(51) Int Cl.:
***C09K 11/02*** *(2006.01)* ***H01L 33/50*** *(2010.01)*

(21) Application number: **13185714.6**

(22) Date of filing: **24.09.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **28.09.2012 JP 2012216864**

(71) Applicant: **NITTO DENKO CORPORATION**
**Ibaraki-shi,**
**Osaka 567-8680 (JP)**

(72) Inventors:
- **Fuji, Hironaka**
**Osaka, 567-8680 (JP)**
- **Shirakawa, Masahiro**
**Osaka, 567-8680 (JP)**
- **Ito, Hisataka**
**Osaka, 567-8680 (JP)**

(74) Representative: **HOFFMANN EITLE**
**Patent- und Rechtsanwälte**
**Arabellastrasse 4**
**81925 München (DE)**

(54) **Phosphor adhesive sheet, optical semiconductor element-phosphor layer pressure-sensitive adhesive body, and optical semiconductor device**

(57) A phosphor adhesive sheet (6) includes a phosphor layer (3) containing a phosphor and an adhesive layer (4) laminated on one surface in a thickness direction of the phosphor layer. The adhesive layer (4) is formed from a silicone pressure-sensitive adhesive composition. A percentage of the peel strength of the phosphor adhesive sheet (6) is 30 % or more.

FIG.2(b)

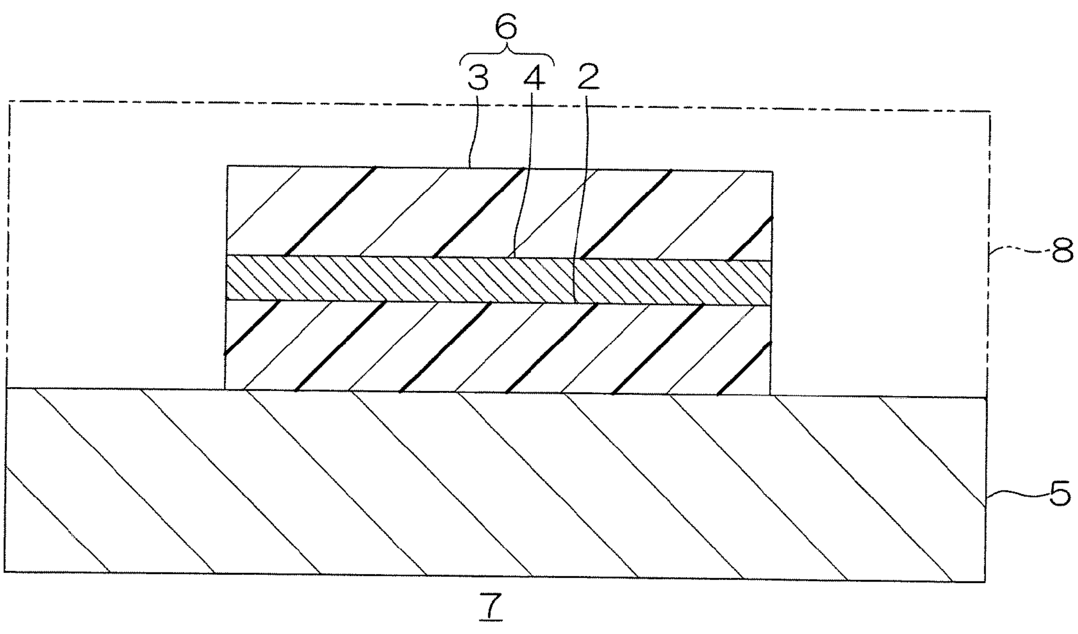




Printed by Jouve, 75001 PARIS (FR)

## Description

BACKGROUND OF THE INVENTION

Field of the Invention

The present invention relates to a phosphor adhesive sheet, an optical semiconductor element-phosphor layer pressure-sensitive adhesive body, and an optical semiconductor device.

Description of Related Art

An optical semiconductor device such as a light emitting diode device (hereinafter, simply referred to as an LED device) and a laser diode irradiation device (hereinafter, simply referred to as an LD irradiation device) includes, for example, an optical semiconductor element such as a light emitting diode element (an LED) and a laser diode (an LD) and a phosphor layer that is disposed on the optical semiconductor element. Such an optical semiconductor device emits white light by color mixing of blue light that is emitted from the optical semiconductor element and transmits through, for example, the phosphor layer and yellow light that is converted in wavelength from a part of the blue light in the phosphor layer.

As such an optical semiconductor device, an LED device that is provided with an LED package in which an LED is encapsulated by a transparent encapsulating material and a phosphor tape that is laminated on the upper surface thereof has been proposed (ref: for example, US Patent Document No. 7,294,861).

The phosphor tape in US Patent Document No. 7,294,861 includes a phosphor layer and an acrylic pressure-sensitive adhesive layer that is laminated on the back surface thereof and is prepared from a (meth)acrylate-based pressure-sensitive adhesive. The phosphor layer is attached to the surface of the LED package via the acrylic pressure-sensitive adhesive layer.

SUMMARY OF THE INVENTION

The temperature of the phosphor tape, however, is easily increased to be a high temperature by light emission of the LED and in the phosphor tape in US Patent Document No. 7,294,861, there is a disadvantage that an adhesive force at a high temperature (for example, a high temperature including 75°C) is remarkably reduced compared to the adhesive force at a normal temperature (25°C).

In addition, there is also a disadvantage that when the phosphor tape in US Patent Document No. 7,294,861 is used at a high temperature for a long time, it is deteriorated, so that the brightness of the LED device is reduced.

It is an object of the present invention to provide a phosphor adhesive sheet, an optical semiconductor element-phosphor layer pressure-sensitive adhesive body, and an optical semiconductor device, each of which has excellent heat resistance and durability.

A phosphor adhesive sheet of the present invention includes a phosphor layer containing a phosphor and an adhesive layer laminated on one surface in a thickness direction of the phosphor layer, wherein the adhesive layer is formed from a silicone pressure-sensitive adhesive composition and a percentage of the following peel strength is 30 % or more.

$$\text{Percentage of peel strength} = [(\text{peel strength } PS_{75°C} \text{ in an atmosphere at } 75°C) / (\text{peel strength } PS_{25°C} \text{ in an atmosphere at } 25°C)] \times 100$$

Peel Strength $PS_{75°C}$ in an atmosphere at 75°C: a peel strength at a temperature of 75°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

Peel Strength $PS_{25°C}$ in an atmosphere at 25°C: a peel strength at a temperature of 25°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

In the phosphor adhesive sheet of the present invention, it is preferable that the percentage of the peel strength is 200 % or less.

In the phosphor adhesive sheet of the present invention, it is preferable that the phosphor layer is formed of a ceramic of the phosphor.

In the phosphor adhesive sheet of the present invention, it is preferable that the phosphor layer is formed from

a phosphor resin composition containing the phosphor and a resin.

An optical semiconductor element-phosphor layer pressure-sensitive adhesive body of the present invention includes an optical semiconductor element and a phosphor adhesive sheet pressure-sensitively adhering to one surface in a thickness direction of the optical semiconductor element, wherein the phosphor adhesive sheet includes a phosphor layer containing a phosphor and an adhesive layer laminated on one surface in the thickness direction of the phosphor layer, and the adhesive layer is formed from a silicone pressure-sensitive adhesive composition and a percentage of the following peel strength is 30 % or more.

$$\text{Percentage of peel strength} = [(\text{peel strength } PS_{75°C} \text{ in an atmosphere at } 75°C) / (\text{peel strength } PS_{25°C} \text{ in an atmosphere at } 25°C)] \times 100$$

Peel Strength $PS_{75°C}$ in an atmosphere at 75°C: a peel strength at a temperature of 75°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

Peel Strength $PS_{25°C}$ in an atmosphere at 25°C: a peel strength at a temperature of 25°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

An optical semiconductor device of the present invention includes a substrate, an optical semiconductor element mounted on the substrate, and a phosphor adhesive sheet pressure-sensitively adhering to one surface in a thickness direction of the optical semiconductor element, wherein the phosphor adhesive sheet includes a phosphor layer containing a phosphor and an adhesive layer laminated on one surface in the thickness direction of the phosphor layer, and the adhesive layer is formed from a silicone pressure-sensitive adhesive composition and a percentage of the following peel strength is 30 % or more.

$$\text{Percentage of peel strength} = [(\text{peel strength } PS_{75°C} \text{ in an atmosphere at } 75°C) / (\text{peel strength } PS_{25°C} \text{ in an atmosphere at } 25°C)] \times 100$$

Peel Strength $PS_{75°C}$ in an atmosphere at 75°C: a peel strength at a temperature of 75°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

Peel Strength $PS_{25°C}$ in an atmosphere at 25°C: a peel strength at a temperature of 25°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

An optical semiconductor device of the present invention includes an optical semiconductor package including a substrate, an optical semiconductor element mounted on the substrate, a reflector formed at one side in a thickness direction of the substrate and disposed, when projected in the thickness direction, so as to surround the optical semiconductor element, and an encapsulating layer filling the inside of the reflector and encapsulating the optical semiconductor element and a phosphor adhesive sheet pressure-sensitively adhering to one surface in the thickness direction of the optical semiconductor package, wherein the phosphor adhesive sheet includes a phosphor layer containing a phosphor and an adhesive layer laminated on one surface in the thickness direction of the phosphor layer, and the adhesive layer is formed from a silicone pressure-sensitive adhesive composition and a percentage of the following peel strength is 30 % or more.

$$\text{Percentage of peel strength} = [(\text{peel strength } PS_{75°C} \text{ in an atmosphere at } 75°C) / (\text{peel strength } PS_{25°C} \text{ in an atmosphere at } 25°C)] \times 100$$

Peel Strength $PS_{75°C}$ in an atmosphere at 75°C: a peel strength at a temperature of 75°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

Peel Strength $PS_{25°C}$ in an atmosphere at 25°C: a peel strength at a temperature of 25°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

In the phosphor adhesive sheet and the optical semiconductor element-phosphor layer pressure-sensitive adhesive body of the present invention, the adhesive layer is formed from the silicone pressure-sensitive adhesive composition and the percentage of the peel strength of the phosphor adhesive sheet is 30 % or more, so that the phosphor adhesive sheet and the optical semiconductor element-phosphor layer pressure-sensitive adhesive body have excellent heat resistance and durability.

Thus, the optical semiconductor device of the present invention is capable of ensuring excellent light emitting reliability over a long period of time.

BRIEF DESCRIPTION OF THE DRAWINGS

FIG. 1 shows a sectional view of one embodiment of a phosphor adhesive sheet of the present invention.

FIG. 2 shows process drawings for illustrating a method for producing an LED device that is one embodiment of an optical semiconductor device of the present invention:

FIG. 2 (a) illustrating a step of preparing a phosphor adhesive sheet and an LED and

FIG. 2 (b) illustrating a step of allowing the phosphor adhesive sheet to pressure-sensitively adhere to the LED.

FIG. 3 shows process drawings for illustrating a method for producing an LED device that is another embodiment of an optical semiconductor device of the present invention:

FIG. 3 (a) illustrating a step of preparing a phosphor adhesive sheet and an LED and

FIG. 3 (b) illustrating a step of allowing the phosphor adhesive sheet to pressure-sensitively adhere to the LED.

FIG. 4 shows process drawings for illustrating a method for producing an LED device that is another embodiment of an optical semiconductor device of the present invention:

FIG. 4 (a) illustrating a step of preparing a substrate and an LED-phosphor layer pressure-sensitive adhesive body and

FIG. 4 (b) illustrating a step of mounting an LED of the LED-phosphor layer pressure-sensitive adhesive body on the substrate.

FIG. 5 shows process drawings for illustrating a method for producing another embodiment of an optical semiconductor device of the present invention:

FIG. 5 (a) illustrating a step of preparing an LED package and a phosphor adhesive sheet and

FIG. 5 (b) illustrating a step of allowing the phosphor adhesive sheet to pressure-sensitively adhere to the LED package.

DETAILED DESCRIPTION OF THE INVENTION

In FIG. 1, a phosphor adhesive sheet 6 as one embodiment of the present invention includes a phosphor layer 3 and an adhesive layer 4 that is laminated on the upper surface (one surface in the thickness direction) of the phosphor layer 3.

The phosphor layer 3 is, for example, a wavelength conversion layer (a phosphor layer) that converts a part of blue light emitted from an LED 2 (ref: FIG. 2) to be described later to yellow light. The phosphor layer 3 may convert a part of the blue light into red light in addition to the above-described wavelength conversion. The phosphor layer 3 is formed into a plate shape or a sheet shape. The phosphor layer 3 is formed of, for example, a ceramic of a phosphor as a phosphor ceramic plate or is formed from a phosphor resin composition containing a phosphor and a resin as a phosphor resin sheet.

The phosphor is excited by absorbing a part or all of light at the wavelength of 350 to 480 nm as an exciting light and emits a fluorescent light whose wavelength is longer than that of the exciting light, for example, in the range of 500 to 650 nm. To be specific, an example of the phosphor includes a yellow phosphor. An example of the phosphor includes a phosphor obtained by doping a rare earth element such as cerium (Ce) or europium (Eu) into a composite metal oxide, a metal sulfide, or the like.

To be specific, examples of the phosphor include a garnet type phosphor having a garnet type crystal structure such as $Y_3Al_5O_{12}$:Ce (YAG (yttrium aluminum garnet):Ce), $(Y, Gd)_3(Al, Ga)_5O_{12}$:Ce, $Tb_3Al_3O_{12}$:Ce, $Lu_3Al_3O_{12}$:Ce, $Ca_3SC_2Si_3O_{12}$:Ce, and $Lu_2CaMg_2(Si, Ge)_3O_{12}$:Ce; a silicate phosphor such as $(Sr, Ba)_2SiO_4$:E $Ca_3SiO_4Cl_2$:Eu, $Sr_3SiO_5$:Eu, $Li_2SrSiO_4$:Eu, and $Ca_3Si_2O_7$:Eu; an aluminate phosphor such as $CaAl_{12}O_{19}$:Mn and $SrAl_2O_4$:Eu; a sulfide

phosphor such as ZnS:Cu,Al, CaS:Eu, $CaGa_2S_4$:Eu, and $SrGa_2S_4$:Eu; an oxynitride phosphor such as $CaSi_2O_2N_2$:Eu, $SrSi_2O_2N_2$:Eu, $BaSi_2O_2N_2$:Eu, and Ca-α-SiAlON; a nitride phosphor such as $CaAlSiN_3$:Eu and $CaSi_5N_8$:Eu; and a fluoride-based phosphor such as $K_2SiF_6$:Mn and $K_2TiF_6$:Mn. Preferably, a garnet type phosphor is used, or more preferably, $Y_3Al_5O_{12}$:Ce (YAG) is used.

These phosphors can be used alone or in combination of two or more.

In order to form the phosphor layer 3 as a phosphor ceramic plate, the phosphor layer 3 (the phosphor ceramic) is obtained by sintering the above-described phosphor as a ceramic material. Alternatively, the phosphor layer 3 (the phosphor ceramic) can be also obtained by a chemical reaction generated by sintering raw materials of the above-described phosphor.

When the phosphor ceramic is obtained, for example, an additive such as a binder resin, a dispersant, a plasticizer, and a sintering additive can be added at an appropriate proportion before the sintering.

On the other hand, when the phosphor layer 3 is formed from a phosphor resin composition, for example, first, the above-described phosphor is blended with a resin, so that a phosphor resin composition is prepared.

The resin is a matrix in which a phosphor is dispersed. An example of the resin includes a transparent resin such as a silicone resin composition, an epoxy resin, and an acrylic resin. Preferably, in view of durability, a silicone resin composition is used.

The silicone resin composition has, in a molecule, a main chain that is mainly composed of a siloxane bond (-Si-O-Si-) and a side chain that is bonded to silicon atoms (Si) of the main chain and is composed of an organic group such as an alkyl group (for example, a methyl group), an aryl group (for example, a phenyl group), or an alkoxyl group (for example, a methoxy group).

To be specific, an example of the silicone resin composition includes a curable type silicone resin such as a dehydration condensation curable type silicone resin, an addition reaction curable type silicone resin, a peroxide curable type silicone resin, and a moisture curable type silicone resin.

The silicone resin composition has a kinetic viscosity at 25°C of, for example, 10 to 30 $mm^2/s$.

These resins can be used alone or in combination of two or more.

The mixing proportion of the components is as follows. The mixing ratio of the phosphor with respect to the phosphor resin composition is, for example, 1 mass % or more, or preferably 5 mass % or more, and is, for example, 50 mass % or less, or preferably 30 mass % or less. The mixing ratio of the phosphor with respect to 100 parts by mass of the resin is, for example, 1 part by mass or more, or preferably 5 parts by mass or more, and is, for example, 100 parts by mass or less, or preferably 40 parts by mass or less.

The mixing ratio of the resin with respect to the phosphor resin composition is, for example, 50 mass % or more, or preferably 70 mass % or more, and is, for example, 99 mass % or less, or preferably 95 mass % or less.

The phosphor resin composition is prepared by blending the phosphor and the resin at the above-described mixing proportion to be stirred and mixed. The prepared phosphor resin composition is formed into a sheet shape and to be specific, is formed as a phosphor resin sheet.

When the resin contains a curable type silicone resin, the phosphor resin sheet is formed in a B-stage state or in a C-stage state. Furthermore, when the phosphor resin sheet is formed in a B-stage state, the phosphor resin sheet can be brought into a C-stage state by the subsequent heating.

In view of thermal conduction of generated heat by the LED 2 and the phosphor layer 3, preferably, the phosphor layer 3 is formed of a phosphor ceramic plate.

When the phosphor layer 3 is formed as the phosphor ceramic plate, the thickness thereof is, for example, 50 μm or more, or preferably 100 μm or more, and is, for example, 1000 μm or less, or preferably 500 μm or less. When the phosphor layer 3 is formed of the phosphor resin sheet, the thickness thereof is, in view of film forming properties and appearance of a device, for example, 25 μm or more, or preferably 50 μm or more, and is, for example, 1000 μm or less, or preferably 200 μm or less.

The adhesive layer 4 is formed on the entire upper surface (one surface in the thickness direction) of the phosphor layer 3. The adhesive layer 4 is formed from a silicone pressure-sensitive adhesive composition into a sheet shape.

The silicone pressure-sensitive adhesive composition is, for example, prepared from a material containing a first polysiloxane, a second polysiloxane, a catalyst, and the like.

The first polysiloxane is a main material of the silicone pressure-sensitive adhesive composition and an example thereof includes a reactive polysiloxane such as a silanol group-containing polysiloxane.

An example of the silanol group-containing polysiloxane includes a polysiloxane containing silanol groups at both ends.

The polysiloxane containing silanol groups at both ends is an organosiloxane that contains silanol groups (SiOH groups) at both ends of a molecule and to be specific, is represented by the following general formula (1).

General Formula (1):

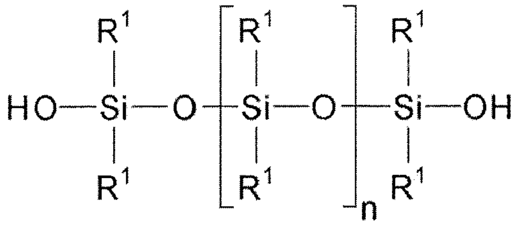

(1)

(where, in general formula (1), $R^1$ represents a monovalent hydrocarbon group selected from a saturated hydrocarbon group and an aromatic hydrocarbon group. "n" represents an integer of 1 or more.)

In the above-described general formula (1), in the monovalent hydrocarbon group represented by $R^1$, examples of the saturated hydrocarbon group include a straight chain or branched chain alkyl group having 1 to 6 carbon atoms (such as a methyl group, an ethyl group, a propyl group, an isopropyl group, a butyl group, an isobutyl group, a pentyl group, and a hexyl group) and a cycloalkyl group having 3 to 6 carbon atoms (such as a cyclopentyl group and a cyclohexyl group).

In the above-described general formula (1), in the monovalent hydrocarbon group represented by $R^1$, an example of the aromatic hydrocarbon group includes an aryl group having 6 to 10 carbon atoms (such as a phenyl group and a naphthyl group).

In the above-described general formula (1), $R^1$ may be the same or different from each other. Preferably, $R^1$s are the same.

As the monovalent hydrocarbon group, preferably, an alkyl group having 1 to 6 carbon atoms and an aryl group having 6 to 10 carbon atoms are used, or more preferably, a methyl group and a phenyl group are used.

In the above-described general formula (1), "n" is preferably an integer of 10,000 or less, or more preferably an integer of 1,000 or less.

"n" in the above-described general formula (1) is calculated as an average value.

To be specific, examples of the polysiloxane containing silanol groups at both ends include a polydimethylsiloxane containing silanol groups at both ends, a polymethylphenylsiloxane containing silanol groups at both ends, and a polydiphenylsiloxane containing silanol groups at both ends.

These first polysiloxanes can be used alone or in combination of a plurality of different types.

Of the first polysiloxanes, preferably, a polydimethylsiloxane containing silanol groups at both ends is used.

A commercially available product can be used as the first polysiloxane. A first polysiloxane synthesized in accordance with a known method can be also used.

The number average molecular weight of the first polysiloxane is, for example, 100 or more, or preferably 200 or more, and is, for example, 1,000,000 or less, or preferably 100,000 or less. The number average molecular weight is calculated by conversion based on standard polystyrene with a gel permeation chromatography.

The mixing ratio of the first polysiloxane in the silicone pressure-sensitive adhesive composition is, for example, 60 mass % or more, or preferably 80 mass % or more, and is, for example, 99.5 mass % or less, or preferably 98 mass % or less.

The second polysiloxane is an auxiliary material of the silicone pressure-sensitive adhesive composition and is added as required, for example, in order to obtain properties such as improvement in the hardness of the adhesive layer 4, improvement in the adhesive force, and improvement in the heat resistance. Examples of the second polysiloxane include a chain type polysiloxane and a cyclic polysiloxane. Preferably, a cyclic polysiloxane is used.

The cyclic polysiloxane is represented by the following general formula (2).

General Formula (2):

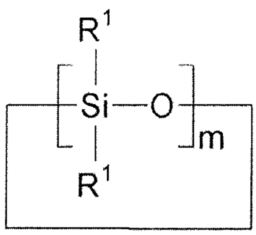

(2)

(where, in general formula (2), $R^1$ represents the same $R^1$ as that in general formula (1). "m" represents an

integer of 2 or more.)

"m" is preferably an integer of 3 or more, and is, for example, an integer of 10 or less, or preferably an integer of 6 or less.

To be specific, an example of the cyclic polysiloxane includes a hexamethylcyclotrisiloxane (where, in general formula (2), $R^1$ is methyl and "m" is 3), an octamethylcyclotetrasiloxane (where, in general formula (2), $R^1$ is methyl and "m" is 4), and a decamethylcyclopentasiloxane (where, in general formula (2), $R^1$ is methyl and "m" is 5).

These second polysiloxanes can be used alone or in combination of a plurality of different types.

Of the second polysiloxanes, preferably, an octamethylcyclotetrasiloxane is used.

The mixing ratio of the second polysiloxane with respect to 100 parts by mass of the first polysiloxane is, for example, 20 parts by mass or less, or preferably 10 parts by mass or less.

An example of the catalyst includes a peroxide. An example of the peroxide includes an organic peroxide such as a benzoyl peroxide including dibenzoyl peroxide, benzoyl m-methylbenzoyl peroxide, and m-toluyl peroxide.

These catalysts can be used alone or in combination.

As the catalyst, preferably, dibenzoyl peroxide, benzoyl m-methylbenzoyl peroxide, and m-toluyl peroxide are used in combination (a mixture).

The mixing ratio of the catalyst with respect to 100 parts by mass of the first polysiloxane is, in view of controlling the hardness of the adhesive layer 4, for example, 0.5 parts by mass or more, or preferably 1 part by mass or more, and is, for example, 10 parts by mass or less, or preferably 5 parts by mass or less.

The above-described material is blended in a solvent as required to prepare a varnish and subsequently, the obtained mixture is allowed to react as required, so that the silicone pressure-sensitive adhesive composition is prepared. An example of the solvent includes an aromatic hydrocarbon such as toluene.

The above-described solvent is distilled off as required after forming a film of the adhesive layer 4.

A commercially available product can be used as the above-described silicone pressure-sensitive adhesive composition. Examples of the commercially available product include 280A, 282, 7355, 7358, 7502, 7657, Q2-7406, Q2-7566, Q2-7735 manufactured by Dow Coming Corporation and PSA 590, PSA 600, PSA 595, PSA 610, PSA 518, PSA 6574, PSA 529, PSA 750-D1, PSA 825-D1, and PSA 800-C manufactured by Momentive Performance Materials Inc.

The thickness of the adhesive layer 4 formed in this way is, in view of pressure-sensitive adhesive properties, for example, 5 μm or more, and is, for example, 200 μm or less, preferably, in view of thermal conduction of generated heat by the LED 2 and the phosphor layer 3, 100 μm or less, or more preferably 50 μm or less.

Next, a method for producing the phosphor adhesive sheet 6 is described.

In this method, first, the phosphor layer 3 is prepared.

Next, the adhesive layer 4 is laminated on the upper surface of the phosphor layer 3.

To be specific, when the silicone pressure-sensitive adhesive composition is prepared as a varnish, the varnish is applied to the entire upper surface of the phosphor layer 3 by a known application method such as a bar coating method. In this way, a film of the silicone pressure-sensitive adhesive composition is formed and subsequently, the solvent is distilled off as required.

Alternatively, the varnish is applied to the surface of a release sheet or the like to form a film. After the solvent is distilled off as required, the film can be transferred from a release sheet to the phosphor layer 3. The release sheet is removed from the adhesive layer 4 at the time of using a phosphor adhesive sheet 6.

In this way, the adhesive layer 4 is formed on the surface of the phosphor layer 3.

In this way, the phosphor adhesive sheet 6 in which the adhesive layer 4 is laminated on the phosphor layer 3 is obtained.

In the phosphor adhesive sheet 6 obtained in this way, a percentage of the following peel strength is 30 % or more, preferably 35 % or more, or more preferably 40 % or more, and is, for example, 200 % or less, or preferably 150 % or less.

$$\text{Percentage of peel strength} = [(\text{peel strength } PS_{75°C} \text{ in an atmosphere at } 75°C) / (\text{peel strength } PS_{25°C} \text{ in an atmosphere at } 25°C)] \times 100$$

Peel Strength $PS_{75°C}$ in an atmosphere at 75°C: a peel strength at a temperature of 75°C at the time of peeling a support and the adhesive layer 4 from the phosphor layer 3 at a peel angle of 180 degrees and a rate of 300 mm/min after allowing the adhesive layer 4 laminated on the support to pressure-sensitively adhere to the phosphor layer 3, that is, a peel strength of the adhesive layer 4 with respect to the phosphor layer 3 in an atmosphere at 75°C.

Peel Strength $PS_{25°C}$ in an atmosphere at 25°C: a peel strength at a temperature of 25°C at the time of peeling a support and the adhesive layer 4 from the phosphor layer 3 at a peel angle of 180 degrees and a rate of 300 mm/min after allowing the adhesive layer 4 laminated on the support to pressure-sensitively adhere to the phosphor layer 3, that

is, a peel strength of the adhesive layer 4 with respect to the phosphor layer 3 in an atmosphere at 25°C.

When the percentage of the peel strength is below 30 %, there is a disadvantage that an interfacial peeling occurs between the adhesive layer 4 and the phosphor layer 3.

On the other hand, when the adhesive force of the adhesive layer 4 is not more than the above-described upper limit, in a case where the LED 2 (ref: FIGS. 2 to 4) or an LED package 10 (ref: FIG. 5), both of which are an object to be allowed to pressure-sensitively adhere, have a damage, the phosphor adhesive sheet 6 is once removed from the LED 2 or the LED package 10, and a repair of repairing the LED 2 or the LED package 10 is capable of being easily performed.

Next, using the phosphor adhesive sheet 6 in FIG. 1, a method for obtaining an LED device 7 as an optical semiconductor device of the present invention is described with reference to FIG. 2.

In this method, as shown by the upper side view in FIG. 2 (a), the phosphor adhesive sheet 6 is prepared.

The phosphor adhesive sheet 6 is trimmed by dicing or the like so as to have the same shape as the outer shape of the LED 2 in plane view.

Along with this, as shown by the lower side view in FIG. 2 (a), the LED 2 as an optical semiconductor element is mounted on a substrate 5 in advance to be prepared.

The LED 2 is formed into a generally flat plate shape in a generally rectangular shape in sectional view and is formed of a known semiconductor material. In the LED 2, though not shown, an LED-side terminal to be electrically connected to a substrate-side terminal in the substrate 5 to be described later is provided.

The substrate 5 is formed into a slightly larger flat plate shape than the LED 2 in plane view. The substrate 5 is formed of, for example, an insulating substrate such as a laminated substrate in which an insulating layer is laminated on a silicon substrate, a ceramic substrate, a polyimide resin substrate, or a metal substrate.

On the upper surface of the substrate 5, a conductive pattern (not shown) including a substrate-side terminal (not shown) to be electrically connected to an LED-side terminal (not shown) in the LED 2 and a wire to be continuous thereto is formed. The conductive pattern is, for example, formed of a conductor such as gold, copper, silver, or nickel.

The LED 2 is connected to the substrate 5 by, for example, flip-chip mounting or wire-bonding connection. When the LED 2 is wire-bonding connected to the substrate 5, the phosphor adhesive sheet 6 to be allowed to pressure-sensitively adhere to the LED 2 is formed into a shape of avoiding (going around) a wire.

Next, in this method, the phosphor adhesive sheet 6 is attached to the LED 2. To be specific, the phosphor layer 3 is allowed to pressure-sensitively adhere to the upper surface of the LED 2 via the adhesive layer 4. That is, the lower surface of the adhesive layer 4 is brought into contact with the upper surface of the LED 2.

The attachment of the phosphor adhesive sheet 6 to the LED 2 is performed at a normal temperature (to be specific, 20 to 25°C). Alternatively, the phosphor adhesive sheet 6 is heated at, for example, 30 to 50°C as required and the attachment thereof can be also performed.

In this way, the LED device 7 including the substrate 5, the LED 2 that is mounted on the substrate 5, and the phosphor adhesive sheet 6 that pressure-sensitively adheres to the upper surface of the LED 2 is obtained.

Thereafter, as shown by a phantom line in FIG. 2 (b), a first encapsulating layer 8 can be provided in the LED device 7 as required. The first encapsulating layer 8 is, on the substrate 5, formed from a transparent resin so as to cover the LED 2 and the phosphor adhesive sheet 6. After the first encapsulating layer 8 is provided in the LED device 7, the size thereof is adjusted by, for example, polishing or dicing as required.

In the phosphor adhesive sheet 6, the adhesive layer 4 is formed from the silicone pressure-sensitive adhesive composition and the percentage of the peel strength of the above-described phosphor adhesive sheet 6 is 30 % or more, so that the phosphor adhesive sheet 6 has excellent heat resistance and durability.

To be more specific, the adhesive force at a high temperature (for example, a high temperature including 75°C) of the phosphor adhesive sheet 6 can be prevented from being remarkably reduced compared to the adhesive force at a normal temperature (25°C) of the phosphor adhesive sheet 6, so that excellent heat resistance is capable of being ensured.

The adhesive layer 4 is formed from the silicone pressure-sensitive adhesive composition, so that a deterioration of the adhesive layer 4 is effectively suppressed, so that a reduction in brightness in the LED device 7 is capable of being suppressed.

As a result, the LED device 7 includes the above-described phosphor adhesive sheet 6, so that the LED device 7 is capable of ensuring excellent light emitting reliability over a long period of time.

In FIG. 3 and the subsequent figures, the same reference numerals are provided for members and steps corresponding to each of those described above, and their detailed description is omitted.

In the LED device 7 in the embodiment in FIG. 2 (b), the phosphor adhesive sheet 6 is allowed to pressure-sensitively adhere to the upper surface only of the LED 2. Alternatively, for example, as shown in FIG. 3 (b), the phosphor adhesive sheet 6 can be also allowed to pressure-sensitively adhere to the upper surface and the side surfaces of the LED 2.

In order to obtain the LED device 7 shown in FIG. 3 (b), as referred in FIG. 1, first, the adhesive layer 4 is

laminated on the entire upper surface of the phosphor layer 3 and thereafter, the resulting product is trimmed in a larger size than that of the LED 2 as required, so that the phosphor adhesive sheet 6 having a larger size than that of the LED 2 is obtained.

Next, the phosphor adhesive sheet 6 is attached to the upper surface and the side surfaces of the LED 2 that is mounted on the substrate 5 in advance.

In the LED device 7, as shown in FIG. 3 (b), the adhesive layer 4 is continuously laminated on the upper surface and the side surfaces of the LED 2.

The phosphor layer 3 is laminated on the surfaces (the upper surface and the side surfaces) of the adhesive layer 4.

The phosphor layer 3 and the adhesive layer 4 are formed into a generally U-shape in sectional view having an opening facing downwardly.

In this way, the phosphor layer 3 pressure-sensitively adheres to both surfaces of the upper surface and the side surfaces of the LED 2 via the adhesive layer 4.

In the embodiment in FIG. 3, the same function and effect as that in FIG. 2 can be achieved.

In the embodiment in FIG. 2, as shown in FIG. 2 (a), the phosphor adhesive sheet 6 is prepared and separately, the LED 2 is mounted on the substrate 5 in advance to be prepared. Thereafter, as shown in FIG. 2 (b), the phosphor adhesive sheet 6 is, on the substrate 5, allowed to pressure-sensitively adhere to the LED 2, so that the LED device 7 is fabricated.

Alternatively, for example, as shown in FIG. 4 (a), first, the phosphor adhesive sheet 6 is allowed to pressure-sensitively adhere to the LED 2. An LED-phosphor layer pressure-sensitive adhesive body 1 made of the phosphor adhesive sheet 6 and the LED 2 as an optical semiconductor element-phosphor layer pressure-sensitive adhesive body is fabricated separately from the substrate 5. Thereafter, as shown in FIG. 4 (b), the LED 2 in the LED-phosphor layer pressure-sensitive adhesive body 1 can be mounted on the substrate 5.

In this method, first, the phosphor adhesive sheet 6 and the LED 2 are prepared to be attached to each other. To be specific, the phosphor layer 3 is allowed to pressure-sensitively adhere to the upper surface of the LED 2 via the adhesive layer 4.

In this way, the LED-phosphor layer pressure-sensitive adhesive body 1 including the LED 2 and the phosphor adhesive sheet 6 that pressure-sensitively adhere to the upper surface (one surface in the thickness direction) of the LED 2 is fabricated.

Next, as shown in FIG. 4 (b), the LED 2 in the LED-phosphor layer pressure-sensitive adhesive body 1 is mounted on the substrate 5.

In this way, the LED device 7 is obtained.

In the embodiment in FIG. 4, the same function and effect as that in FIG. 2 can be achieved. The LED-phosphor layer pressure-sensitive adhesive body 1 includes the phosphor adhesive sheet 6, so that it has excellent heat resistance and durability.

In the embodiments in FIGS. 2 and 3, the phosphor adhesive sheet 6 is attached to the LED 2. Alternatively, for example, as shown in FIG. 5, the phosphor adhesive sheet 6 can be attached to the LED package 10.

In FIG. 5 (a), the LED package 10 includes the substrate 5, the LED 2 that is mounted on the substrate 5, a reflector 11 that is formed on the substrate 5 and is disposed, when projected in the thickness direction, so as to surround the LED 2, and a second encapsulating layer 12 that fills the inside of the reflector 11 and encapsulates, as an encapsulating layer, the LED 2.

The LED 2 is mounted on the substrate 5 in advance.

The reflector 11 is, in plane view, formed into a generally rectangular frame shape or a generally ring shape (a circular ring shape or an elliptical ring shape) having an opening in its center. The reflector 11 is also, in sectional view, formed into a generally trapezoidal shape in which its width is gradually reduced toward the upper side. The reflector 11 is disposed at spaced intervals to the LED 2 so as to surround the LED 2. That is, the LED 2 is disposed in the inside of the reflector 11.

The reflector 11 is, for example, formed from a sintered body of a ceramic material that contains a light reflecting component (for example, a titanium oxide) or a reflecting resin composition that contains a light reflecting component. The reflector 11 reflects light emitted from the LED 2.

The second encapsulating layer 12 fills the inside of the reflector 11. To be specific, the second encapsulating layer 12 is formed so as to cover the inner side surfaces of the reflector 11, a portion of the upper surface of the substrate 5 that is exposed from the LED 2, and the upper surface and the outer side surfaces of the LED 2.

The upper surface of the second encapsulating layer 12 is formed so as to form the same plane surface along the plane direction (a direction perpendicular to the thickness direction) as the upper surface of the reflector 11. In the upper surface of the second encapsulating layer 12, though not shown, a concave portion (not shown) that gradually dents downwardly from the circumference end portion toward the central portion may be formed.

In order to attach the phosphor adhesive sheet 6 to the LED package 10, as shown in FIG. 5 (a), the phosphor

adhesive sheet 6 and the LED package 10 are prepared, respectively.

Next, as shown in FIG. 5 (b), the phosphor adhesive sheet 6 is attached to the upper surface of the LED package 10 at, for example, a normal temperature (to be specific, 20 to 25°C).

In this way, the LED device 7 including the LED package 10 in which the phosphor layer 3 is allowed to pressure-sensitively adhere to the upper surface (one surface in the thickness direction) thereof via the adhesive layer 4 can be produced.

In the embodiment in FIG. 5, the same function and effect as that in FIG. 2 can be achieved.

In the embodiments in FIGS. 2 to 5, the LED 2 is illustrated and described as an optical semiconductor element of the present invention. Alternatively, for example, an LD (laser diode) 2 can be used.

In such a case, a laser diode irradiation device 7 serves as the LED device 7, an LD-phosphor layer pressure-sensitive adhesive body 1 serves as the LED-phosphor layer pressure-sensitive adhesive body 1, and an LD package 10 serves as the LED package 10.

Examples

While the present invention will be described hereinafter in further detail with reference to Production Examples, Preparation Examples, Comparative Preparation Examples, Examples, and Comparative Examples, the present invention is not limited to these Production Examples, Preparation Examples, Comparative Preparation Examples, Examples, and Comparative Examples.

(Production of Phosphor Ceramic Plate)

Production Example 1

Material powders of a phosphor prepared from 11.34 g of yttrium oxide particles (purity of 99.99 %, lot: N-YT4CP, manufactured by NIPPON YTTRIUM CO., LTD.), 8.577 g of aluminum oxide particles (purity of 99.99 %, part number "AKP-30", manufactured by Sumitomo Chemical Co., Ltd.), and 0.087 g of cerium oxide particles were prepared.

20 g of the prepared material powders of the phosphor and a water-soluble binder resin ("WB4101", manufactured by Polymer Innovations, Inc.) were mixed so as to have a volume ratio of the solid content of 60:40. Furthermore, distilled water was added to the obtained mixture to be poured into a vessel made of alumina. An yttrium stabilized zirconia ball having a diameter of 3 mm was added thereto and was wet-blended with a ball mill for 24 hours, so that a slurry solution of the material powders of the phosphor was prepared.

Next, the prepared slurry solution was tape-casted on a PET film by a doctor blade method and was dried at 70°C, so that a ceramic green sheet was formed. Thereafter, the ceramic green sheet was peeled from the PET film, so that a ceramic green sheet having a thickness of 90 $\mu$m was obtained.

Thereafter, the obtained green sheet was cut into pieces each having a size of 20 mm $\times$ 20 mm. Two pieces thereof were fabricated and stacked to be thermally laminated using a biaxial hot press, so that a ceramic green sheet laminate was fabricated.

Thereafter, the fabricated ceramic green sheet laminate was heated up to 1200°C at a temperature rising rate of 1°C/min in the air in an electric muffle furnace to perform a binder-removing treatment in which an organic component such as a binder resin was decomposed and removed. Then, the laminate was transferred into a high-temperature vacuum furnace and was heated up to 1750°C at a temperature rising rate of 5°C/min in a reduced pressure atmosphere of about $10^{-3}$ Torr ($133 \times 10^{-3}$ N/cm$^2$) to be sintered at the temperature for five hours, so that a phosphor ceramic plate (a phosphor sheet) having a thickness of 150 $\mu$m was fabricated.

(Fabrication of Phosphor Resin Sheet)

Production Example 2

A solution in which YAG phosphor powders (part number: BYW01A, an average particle size of 9 $\mu$m, manufactured by Phosphor Tech Corporation) were dispersed into a two-liquid mixed type thermosetting silicone elastomer (manufactured by Shin-Etsu Chemical Co., Ltd., part number: KER2500) so that the concentration of the YAG phosphor powders was 25 mass % was applied onto a glass plate using an applicator, so that a phosphor film having a thickness of 150 $\mu$m was formed. The obtained phosphor film was heated at 100°C for one hour and subsequently, was heated at 150°C for one hour, so that a phosphor resin sheet (a phosphor sheet) in a C-stage state having a thickness of 150 $\mu$m was fabricated.

(Preparation of Silicone Pressure-Sensitive Adhesive Composition)

Preparation Example 1

A silicone pressure-sensitive adhesive composition (trade name: PSA 600, manufactured by Momentive Performance Materials Inc.) was prepared.

Materials of the silicone pressure-sensitive adhesive composition were as follows.

Polydimethylsiloxane containing silanol groups at both ends

Octamethylcyclotetrasiloxane (where, in general formula (2), $R^1$: all methyl and "m": 3) 1 to 5 mass % (with respect to the total amount of the solid content)

·Mixture of benzoyl peroxides (a mixture of dibenzoyl peroxide, benzoyl m-methylbenzoyl peroxide, and m-toluyl peroxide)

a small amount

·Toluene

45 mass % with respect to the solid content

(Preparation of Silicone Pressure-Sensitive Adhesive Composition)

Comparative Preparation Example 1

A silicone pressure-sensitive adhesive composition (trade name: SD 4580 PSA, manufactured by Dow Coming Toray Co., Ltd.) was prepared.

Materials of the silicone pressure-sensitive adhesive composition were as follows.

·Polydimethylsiloxane containing silanol groups at both ends

·Mixture of benzoyl peroxides (a mixture of dibenzoyl peroxide, benzoyl m-methylbenzoyl peroxide, and m-toluyl peroxide)

a small amount

·Toluene

70 mass % with respect to the solid content

(Preparation of Acrylic Pressure-Sensitive Adhesive Composition)

Comparative Preparation Example 2

An acrylic pressure-sensitive adhesive was prepared with reference to the formulation of Example 2 in Japanese Unexamined Patent Publication No. H6-172729.

(Production of Phosphor Adhesive Sheet and LED Device)

Example 1

The silicone pressure-sensitive adhesive composition in Preparation Example 1 was applied to the entire upper surface of the phosphor ceramic plate in Production Example 1, so that a film was formed. Subsequently, a solvent was distilled off.

In this way, a silicone pressure-sensitive adhesive layer (an adhesive layer) having a thickness of 40 μm was formed (ref: FIG. 1).

Thereafter, the phosphor ceramic plate and the silicone pressure-sensitive adhesive layer were collectively subjected to dicing, so that a phosphor adhesive sheet having a size of 1 mm × 1 mm was fabricated (ref: the upper side view in FIG. 2 (a)).

Thereafter, the phosphor adhesive sheet was attached to an LED (manufactured by Cree, Inc.) (ref: FIG. 2 (a)) that was mounted on the substrate in advance and had the same size as that of the phosphor adhesive sheet at 25°C (ref: FIG. 2 (b)). That is, the phosphor ceramic plate was allowed to pressure-sensitively adhere to the LED via the silicone pressure-sensitive adhesive layer.

In this way, an LED device was produced.

Example 2

A phosphor adhesive sheet was obtained (ref. FIG. 1) and subsequently, an LED device was produced (ref: FIG. 2 (b)) in the same manner as in Example 1, except that the phosphor resin sheet in Production Example 2 was used instead of the phosphor ceramic plate in Production Example 1.

Example 3

A phosphor adhesive sheet was obtained (ref: FIG. 1) and subsequently, an LED device was produced (ref: FIG. 2 (b)) in the same manner as in Example 1, except that the thickness of the silicone pressure-sensitive adhesive layer was changed to 60 μm.

Example 4

A phosphor adhesive sheet was obtained (ref: FIG. 1) and subsequently, an LED device was produced (ref: FIG. 2 (b)) in the same manner as in Example 1, except that the thickness of the silicone pressure-sensitive adhesive layer was changed to 120 μm.

Comparative Example 1

A phosphor adhesive sheet was obtained (ref: FIG. 1) and subsequently, an LED device was produced (ref: FIG. 2 (b)) in the same manner as in Example 1, except that the silicone pressure-sensitive adhesive composition in Comparative Preparation Example 1 was used instead of the silicone pressure-sensitive adhesive composition in Preparation Example 1.

Comparative Example 2

A phosphor adhesive sheet was obtained (ref: FIG. 1) and subsequently, an LED device was produced (ref: FIG. 2 (b)) in the same manner as in Example 1, except that the acrylic pressure-sensitive adhesive composition in Comparative Preparation Example 2 was used instead of the silicone pressure-sensitive adhesive composition in Preparation Example 1.

Comparative Example 3

A phosphor adhesive sheet was obtained (ref: FIG. 1) and subsequently, an LED device was produced (ref: FIG. 2 (b)) in the same manner as in Example 2, except that the acrylic pressure-sensitive adhesive composition in

Comparative Preparation Example 2 was used instead of the silicone pressure-sensitive adhesive composition in Preparation Example 1.

The materials and the like used in the phosphor layers and the adhesive layers in Examples and Comparative Examples are shown in Table 1.

Table 1

Table 1

| | Adhesive Layer | | Phosphor Layer |
|---|---|---|---|
| | Type | Thickness [μm] | |
| Ex. 1 | Silicone Pressure-Sensitive Adhesive Composition PSA600 | 40 | Ceramic Plate |
| Ex. 2 | Silicone Pressure-Sensitive Adhesive Composition PSA600 | 40 | Phosphor Resin Sheet |
| Ex. 3 | Silicone Pressure-Sensitive Adhesive Composition PSA600 | 60 | Ceramic Plate |
| Ex. 4 | Silicone Pressure-Sensitive Adhesive Composition PSA600 | 120 | Ceramic Plate |
| Comp. Ex. 1 | Silicone Pressure-Sensitive Adhesive Composition SD4580 | 40 | Ceramic Plate |
| Comp. Ex. 2 | Acrylic Pressure-Sensitive Adhesive Composition | 40 | Ceramic Plate |
| Comp. Ex. 3 | Acrylic Pressure-Sensitive Adhesive Composition | 40 | Phosphor Resin Sheet |

(Evaluation)

The peel strength of each of the pressure-sensitive adhesive layers in Examples and Comparative Examples with respect to the phosphor sheet was evaluated by the following method.

The surface temperature of the phosphor adhesive sheet at the time of lighting up each of the LED devices in Examples and Comparative Examples and the light emitting reliability thereof with the passing of time were evaluated. The results are shown in Table 2.

1. Peel Strength

The peel strength under an atmosphere at 25° and 75°C of the pressure-sensitive adhesive layer with respect to the phosphor ceramic plate was calculated by a removing adhesive force measurement [N/19 mm] at a width of 19 mm.

To be more specific, a pressure-sensitive adhesive composition was applied onto the surface of a polyimide film having a thickness of 25 μm as a support so as to have a width of 19 mm and a thickness of 40 μm. In this way, a pressure-sensitive adhesive layer laminated on the support was formed. Next, a polyimide film including the pressure-sensitive adhesive layer was compressively bonded to a phosphor ceramic plate having a size of 20 mm × 20 mm by one reciprocation of a 2 kg roller on the polyimide film. After the compression bonding, the obtained product was allowed to stand for about 30 minutes and then, was set in a tensile test device (name of device: manufactured by Shimadzu Corporation, tensile test device in thermostatic chamber: AUTOGRAPH AG-10kNX) provided in a thermostatic chamber in which the temperature was set to be a predetermined temperature to be retained under the following temperature atmosphere for five minutes. Thereafter, the polyimide film, along with the pressure-sensitive adhesive layer, was removed (peeled) from the phosphor ceramic plate under the following conditions and the removing adhesive force at the time was measured as the peel strength.

Temperature in thermostatic chamber: 25°C or 75°C

Peeling (removing) conditions: peel angle of 180 degrees

Peeling (removing) conditions: tensile rate of 300 mm/min

After the measurement, a percentage ($[PS_{75°C} / PS_{25°C}] \times 100$) of the peel strength $PS_{75°C}$ [N/19 mm] in an atmosphere at 75°C with respect to the peel strength $PS_{25°C}$ [N/19 mm] in an atmosphere at 25°C was calculated.

2. Surface Temperature of Phosphor Layer at Time of Lighting Up LED Device

Each of the LED devices in Examples and Comparative Examples was connected to a heat sink in a sufficient size by thermally conductive grease and was also electrically connected to a power source. Next, an electric current of 350 mA was applied from the power source to allow the LED device to emit light. The surface temperature of the phosphor layer after being allowed to emit light for one minute was measured with a thermography.

In Comparative Example 1, the adhesive layer was peeled from the phosphor ceramic plate. Thus, the surface temperature of the phosphor layer was not capable of being measured.

3. Light Emitting Reliability with Passing of Time

The light emission brightness (the initial brightness) of each of the LED devices fabricated in the above-described 2 at the time of being subjected to initial light emission at an electric current of 350 mA and the brightness (the brightness after 30 days) thereof after being allowed to emit light continuously for 30 days were measured, respectively.

A percentage ([brightness after 30 days / initial brightness] × 100) of the brightness after 30 days with respect to the initial brightness was calculated.

In Comparative Example 1, the adhesive layer was peeled from the phosphor ceramic plate. Thus, the brightness after 30 days was not capable of being measured and therefore, the above-described percentage was not capable of being calculated.

Table 2

Table 2

| | Percentage of Peel Strength *1 [%] | Surface Temperature of Phosphor Layer [°C] | Percentage of Brightness (350 mA) (Brightness after 30 Days/Initial Brightness) [%] |
|---|---|---|---|
| Ex. 1 | 49 (3.5/7.1) | 78 | 99 |
| Ex. 2 | 49 (3.5/7.1) | 86 | 98 |
| Ex. 3 | 49 (3.5/7.1) | 82 | 98 |
| Ex. 4 | 49 (3.5/7.1) | 98 | 96 |
| Comp. Ex. 1 | 26 (0.31/1.2) | Unmeasurable *2 | - |
| Comp. Ex. 2 | 60 (3.5/5.8) | 79 | 63 |
| Comp. Ex. 3 | 60 (3.5/5.8) | 86 | 58 |
| *1: (Peel strength $PS_{75°C}$ (N/19 mm) / (Peel strength $PS_{25°C}$ (N/19 mm)] × 100<br>*2: The adhesive layer was peeled from the phosphor ceramic plate. | | | |

## Claims

**1.** A phosphor adhesive sheet (6) comprising:

a phosphor layer (3) containing a phosphor and
an adhesive layer (4) laminated on one surface in a thickness direction of the phosphor layer, wherein
the adhesive layer (4) is formed from a silicone pressure-sensitive adhesive composition
and
a percentage of the following peel strength is 30 % or more, wherein

$$\text{the percentage of peel strength} = [(\text{peel strength } PS_{75°C} \text{ in an atmosphere at } 75°C) / (\text{peel strength } PS_{25°C} \text{ in an atmosphere at } 25°C)] \times 100,$$

with the peel strength $PS_{75°C}$ in an atmosphere at 75°C being a peel strength at a temperature of 75°C at the time of peeling a support and the adhesive layer from the phosphor layer at a peel angle of 180 degrees and a rate of 300 mm/min after allowing the adhesive layer laminated on the support to pressure-sensitively adhere to the phosphor layer, and
the peel strength $PS_{25°C}$ in an atmosphere at 25°C being a peel strength at a temperature of 25°C at the time of peeling a support and the adhesive layer from the phosphor layer at a peel angle of 180 degrees and a rate of 300 mm/min after allowing the adhesive layer laminated on the support to pressure-sensitively adhere to the phosphor layer.

**2.** The phosphor adhesive sheet (6) according to claim 1, wherein
the percentage of the peel strength is 200 % or less.

**3.** The phosphor adhesive sheet (6) according to claim 1 or 2, wherein

the phosphor layer (3) is formed of a ceramic of the phosphor.

**4.** The phosphor adhesive sheet (6) according to claim 1 or 2, wherein
the phosphor layer (3) is formed from a phosphor resin composition containing the phosphor and a resin.

**5.** An optical semiconductor element-phosphor layer pressure-sensitive adhesive body comprising:

an optical semiconductor element (2) and
a phosphor adhesive sheet (6) according to any of the preceding claims, pressure-sensitively adhering to one surface in a thickness direction of the optical semiconductor element (2).

**6.** An optical semiconductor device (7) comprising:

a substrate (5),
an optical semiconductor element (2) mounted on the substrate (5), and
a phosphor adhesive sheet (3) according to any of claims 1 to 4, pressure-sensitively adhering to one surface in a thickness direction of the optical semiconductor element (2).

**7.** An optical semiconductor device (7) comprising:

an optical semiconductor package (10) including a substrate (5), an optical semiconductor element (2) mounted on the substrate, a reflector (11) formed at one side in a thickness direction of the substrate and disposed, when projected in the thickness direction, so as to surround the optical semiconductor element, and an encapsulating layer (12) filling the inside of the reflector (11) and encapsulating the optical semiconductor element (2) and
a phosphor adhesive sheet (3) according to any of claims 1 to 4, pressure-sensitively adhering to one surface in the thickness direction of the optical semiconductor package (10).

FIG.1

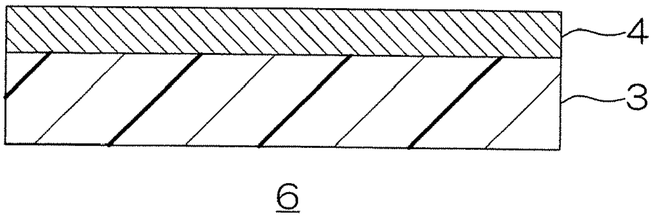

FIG.2

FIG.2(a)

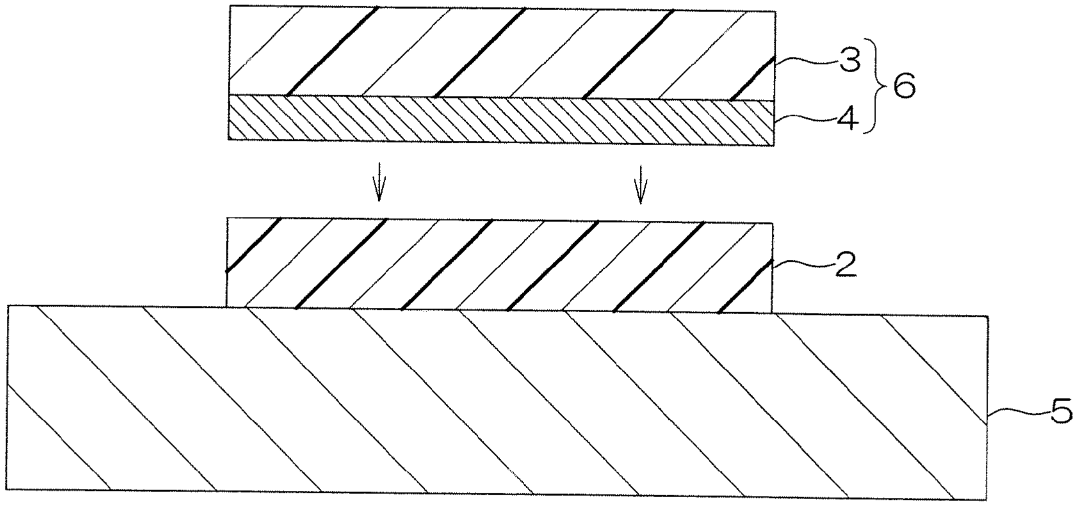


FIG.2(b)

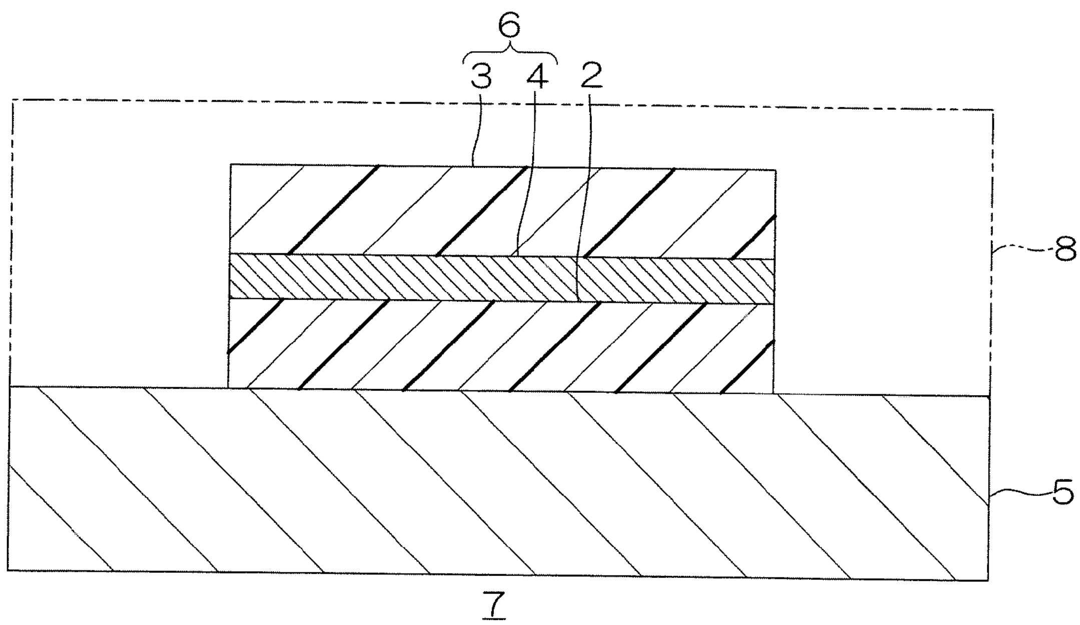

FIG.3

FIG.3(a)

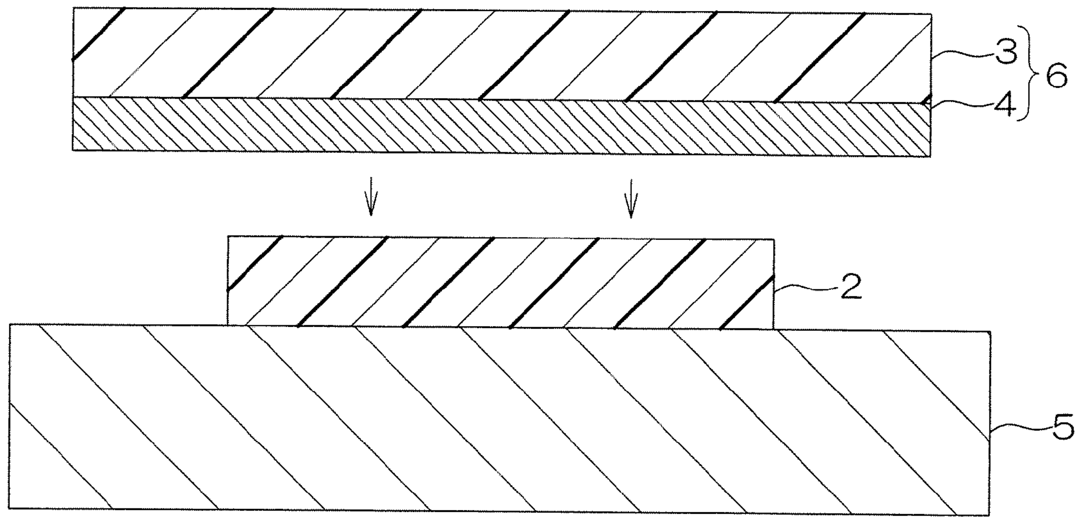


FIG.3(b)

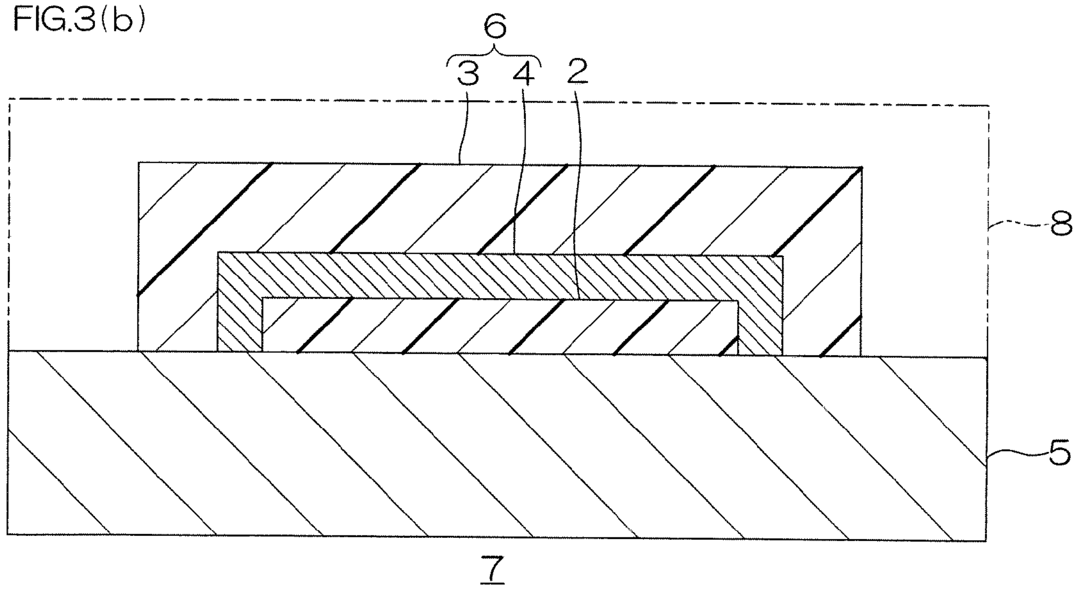

FIG.4

FIG.4(a)

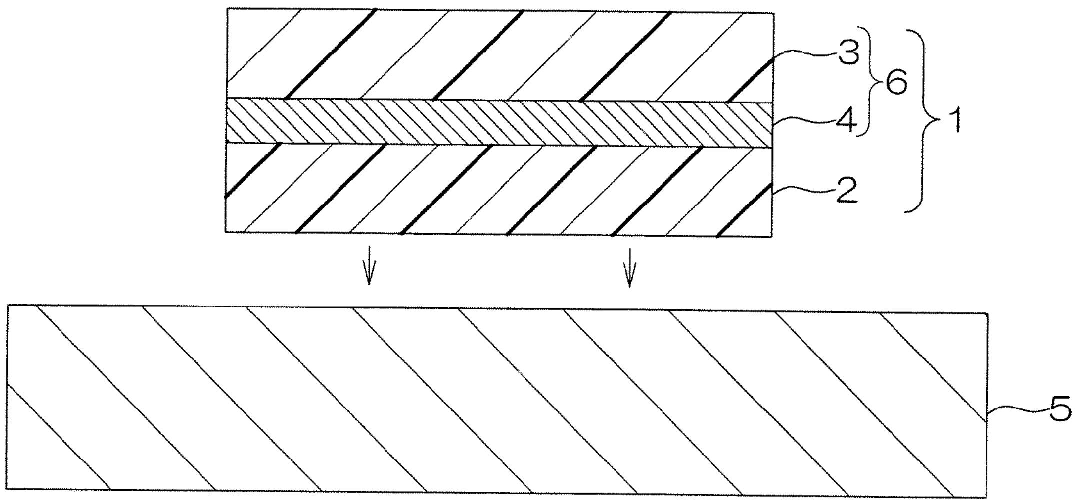


FIG.4(b)

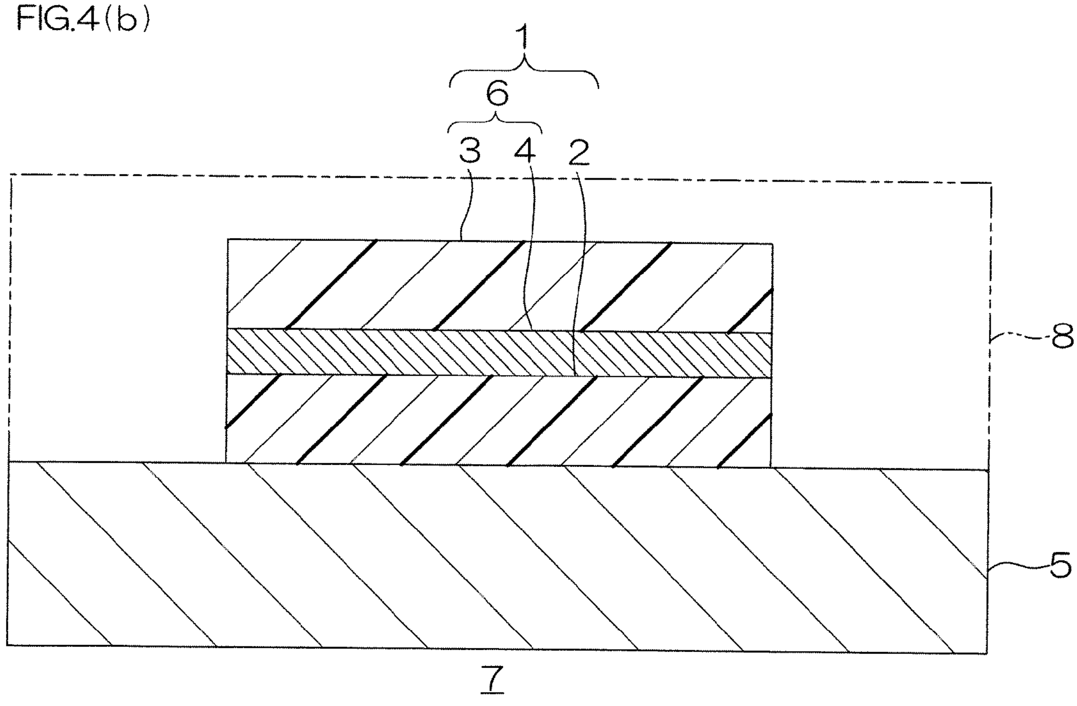

FIG.5

FIG.5(a)

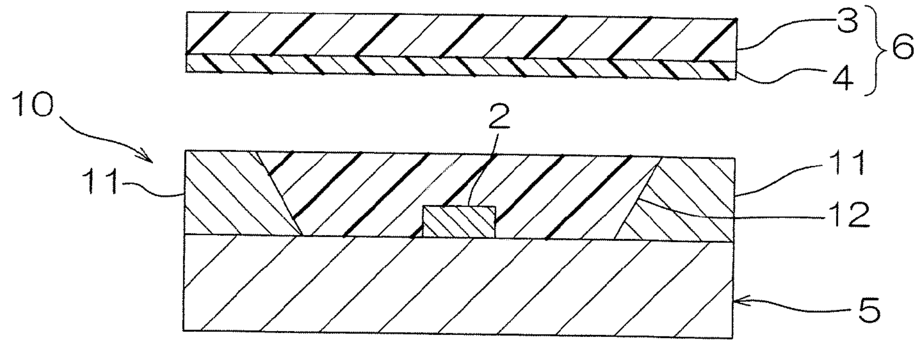


FIG.5(b)

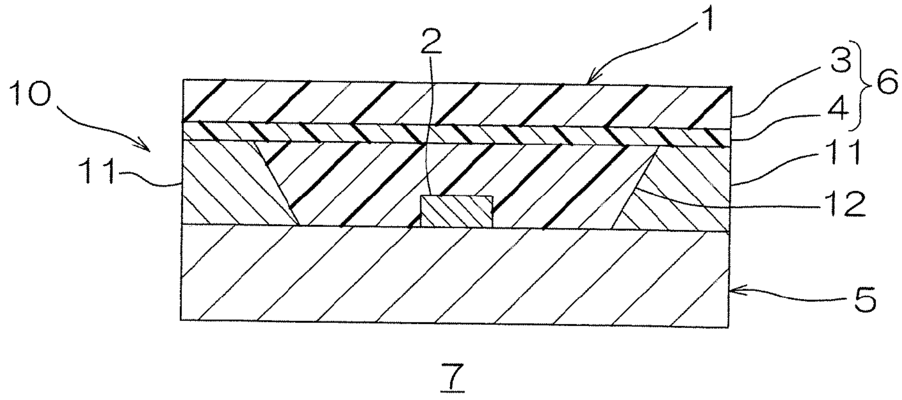

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 7294861 B
- JP H6172729 B